# EUROPÄISCHE PATENTANMELDUNG

(11) **EP 0 975 008 A1**
(43) Veröffentlichungstag der Anmeldung: **26.01.2000**
(21) Anmeldenummer: 98810697.7
(22) Anmeldetag: 20.07.1998
(51) Int. Cl.: H01L 21/00

(54) **Verfahren und Vorrichtung zum Behandeln eines flächigen Werkstückes, insbesondere eines Halbleiterwafers**

(71) Anmelder: Alphasem AG, 8572 Berg (CH)
(72) Erfinder: Stark, Kurt, 8572 Berg (CH); Keller, Markus, 8583 Sulgen (CH)
(74) Vertreter: Wenger, René

(57) **Zusammenfassung**

Die Bearbeitung von Halbleiterwafern wird durch den Einsatz von Adapterrahmen wesentlich vereinfacht. Die Halbleiterwafer sind dabei auf an sich bekannte Weise auf einer Trägerfolie aufgeklebt, die über einen Folienrahmen gespannt ist. Die Trägerfolien werden normalerweise unmittelbar auf dem Aufnahmetisch einer Behandlungsmaschine nachgespannt. Mit Hilfe eines Adapterrahmens (32) können die Trägerfolien aber bereits im nachgespannten Zustand zwischengelagert und in einer Maschine gehandhabt werden. Auf diese Weise werden auch Beschädigungen des Wafers infolge Durchhang der Trägerfolie bei grossen Waferdurchmessern verhindert. Jeder Adapterrahmen besteht aus einem Klemmring (5) und einem Basisring (21) mit einem aufschraubbaren Gewindering (12) als Auflage für den Folienrahmen (2).

## Beschreibung

Die Erfindung betrifft ein Verfahren zum Behandeln eines flächigen Werkstückes, insbesondere eines Halbleiterwafers, gemäss dem Oberbegriff von Anspruch 1.

Damit beispielsweise die auf einem Siliziumwafer vorgefertigten Chips in einer Sägevorrichtung zersägt oder in einem Chipmontageautomaten verarbeitet werden können, muss der Wafer exakt positioniert und blasenfrei auf eine Trägerfolie aufgeklebt werden. Die Folie ist dabei auf einem ringförmigen Folienrahmen, einen sog. Waferframe gespannt. Auf diese Weise lässt sich der sehr dünne und brüchige Wafer leicht lagern, transportieren und verarbeiten. Für die exakte Entnahme der Chips von der Klebefolie im Bestückungsautomaten (Die bonder) muss die Trägerfolie nachgespannt werden, wobei eine geringfügige Expansion des Wafers erzielt wird. Dabei entstehen Zwischenräume zwischen den einzelnen Chips, was die Entnahme erleichtert.

Das Nachspannen der Trägerfolie erfolgt bei bekannten Verfahren unmittelbar in der Behandlungsvorrichtung, also beispielsweise auf dem Aufnahmetisch des Bestückungsautomaten. Dazu wird beispielsweise ein Spannring gegen die Trägerfolie gepresst, was sich etwa mit dem Spannen einer Trommel vergleichen lässt. Auch Vakuumvorrichtungen sind bekannt, bei denen die Trägerfolie unter Vakuum in eine umlaufende Nut gesaugt und dadurch gespannt wird (US-A-4,744,550).

Ein Nachteil der bekannten Verfahren besteht allerdings darin, dass die Folienrahmen nicht genormt sind, und dass die Nachspannvorrichtung jeweils immer dem entsprechenden Rahmen angepasst werden muss. Dies erfordert teilweise aufwendige Maschinenumrüstungen. Ausserdem hat es sich gezeigt, dass bei dem immer grösser werdenden Durchmesser der Halbleiterwafer und damit der Folienrahmen, ein nicht mehr tolerierbarer Durchhang der Trägerfolie auftritt. Bei der Handhabung der Folienrahmen können dabei beispielsweise einzelne Chips mit den Kanten gegeneinander stossen und sich gegenseitig beschädigen (chipping).

Es ist daher eine Aufgabe der Erfindung, ein Verfahren der eingangs genannten Art zu schaffen, bei dem das Nachspannen der Trägerfolie nicht mehr unmittelbar in der Behandlungsebene erfolgt und bei dem auch grössere Waferdurchmesser gefahrlos und ohne Beschädigung der Chips handhabbar sind. Ausserdem soll insgesamt eine grössere Flexibilität bei der Fertigung zwischen den Prozess-Stufen Waferherstellung und Chipverarbeitung erreicht werden.

Diese Aufgabe wird erfindungsgemäss mit einem Verfahren gelöst, das die Merkmale im Anspruch 1 aufweist. Das Befestigen des Folienrahmens auf einem quasi übergeordneten Adapterrahmen und das dabei stattfindende Nachspannen der Trägerfolie bewirkt zunächst einmal, dass der Nachspannprozess nicht erst auf einem Behandlungstisch, sondern unmittelbar zu einem beliebigen früheren Zeitpunkt erfolgen kann. Aufgrund des Fliessverhaltens der Trägerfolie neigt diese nämlich zum Nachdehnen nach dem eigentlichen Spannvorgang. Da der Nachspannvorgang im Adapterrahmen lange vor dem eigentlichen Bearbeitungsprozess stattfindet, ist der Nachdehnprozess beim Erreichen des Behandlungstisches abgeschlossen.

Bei einer Zwischenlagerung oder einem maschinellen Transport, können keine Beschädigungen infolge Durchbiegung mehr stattfinden. Die erforderlichen Prozess-Stufen werden im nachgespannten Zustand auf dem Adapterrahmen durchlaufen. Die Behandlungsmaschine muss ausserdem nur noch standardisierte Adapterrahmen aufnehmen und nicht mehr Folienrahmen von unterschiedlichen Dimensionen. Ausserdem ist nach der Abarbeitung eines Werkstückes kein längerer Maschinenunterbruch mehr nötig, weil jeweils ein zweiter Adapterrahmen geladen werden kann, der an der Bearbeitungsstation sofort einsatzfähig ist.

Das Anschlagmittel dient als Schnittstelle zum Positionieren des Adapterrahmens in der Prozess-Stufe in einer horizontalen oder vertikalen oder einer beliebigen anderen Arbeitsebene. Diese standardisierte Schnittstelle erleichtert und vereinfacht die Handhabung bei jedem Arbeitsprozess.

Das Werkstück kann auf dem Adapterrahmen in einer Sägevorrichtung in Einzelteile, beispielsweise in einzelne Chips gesägt werden. Auf diese Weise wird bereits beim Sägen bzw. unmittelbar nach dem Schnitt, eine Beschädigung des Werkstücks verhindert. Das Nachspannen der Trägerfolie kann vor oder nach dem Sägen erfolgen. Wichtig ist dabei lediglich, dass der Folienrahmen im Adapterrahmen bereits vor dem Nachspannen ausreichend fixiert ist. Das in mehrere Einzelteile unterteilte Werkstück kann auf dem Adapterrahmen aber auch in einer Bestückungsvorrichtung auf einem Aufnahmetisch in einer Aufnahmeebene gehalten werden, in welcher taktweise Einzelteile von der Trägerfolie abgelöst und in einer Abgabeebene wieder abgesetzt werden.

Besonders vorteilhaft lässt sich das Verfahren durchführen, wenn die Trägerfolie am Adapterrahmen mittels eines am Folienrahmen angreifenden Klemmrings über eine zwischen Werkstück und Folienrahmen umlaufende Spannkante an einem Basisring gespannt wird, bis eine vorbestimmte Spannkraft oder eine vorbestimmte Position erreicht ist und wenn anschliessend der Klemmring mit dem Basisring verrastet wird. Der Spannvorgang lässt sich dabei weitgehend automatisieren.

Zu diesem Zweck kann der Basisring auf einer Hubvorrichtung plaziert werden und nach der Auflage eines Folienrahmens auf die Spannkante zum Verrasten gegen den relativ feststehenden Klemmring gepresst werden. Das Schliessen bzw. Verrasten des Adapterrahmens kann in der Behandlungsmaschine, also beispielsweise in einer Sägevorrichtung oder in einer Bestückungsvorrichtung erfolgen.

Die Erfindung betrifft auch eine Vorrichtung zum Nachspannen einer über einen Folienrahmen gespannten Trägerfolie für ein flächiges Werkstück, insbesondere für einen Halbleiterwafer, mit den Merkmalen gemäss Anspruch 6. Das Ausdehnen der Trägerfolie zwischen einem Basisring und einem Klemmring mit Hilfe des Spannmittels bewirkt eine gleichmässige Dehnung der Trägerfolie gegen die Aussenseite hin. Die Dehnung über die Spannkante erfolgt dabei relativ langsam, was sich im Hinblick auf die Nachdehnung der Kunststoff-Folie vorteilhaft auswirkt. Basisring und Klemmring bilden zusammen einen Adapterrahmen, der auch Folienrahmen unterschiedlicher Grösse oder unterschiedlicher Konfiguration aufnehmen kann. Die Anschlagmittel am Adapterrahmen ermöglichen unabhängig von der Ausbildung des Folienrahmens eine Einspannung in einer beliebigen Behandlungsvorrichtung.

Der Basisring kann dabei eine relativ zur Ebene der Spannkante verstellbare Auflageschulter für den Folienrahmen aufweisen. Auf diese Weise lässt sich die gewünschte Spannkraft auf der Trägerfolie besonders leicht einstellen. Die Auflageschulter kann dabei durch einen Gewindering gebildet werden, der auf einen mit einem Aussengewinde versehenen Halsabschnitt am Basisring aufgeschraubt ist. Auch bei relativ grossen Durchmessern ist auf diese Weise eine feine und verkantungsfreie Einstellung leicht möglich. Die Auflageschulter könnte aber auch durch einen Schiebering gebildet werden, der mittels Klemmschrauben od. dgl. am Basisring befestigt wird. Auch eine motorische Verstellung der Auflageschulter wäre denkbar, was ein vollautomatisches Anfahren einer vorbestimmten Position ermöglichen würde.

Als Spannmittel sind vorteilhaft mehrere über den Umfang des Adapterrahmens verteilte Rastelemente angeordnet, an denen der Klemmring und der Basisring unter Federvorspannung miteinander verrastbar sind. Die Federkraft sorgt dafür, dass die Spannung an der Trägerfolie aufrechterhalten wird. Die Rastelemente lassen sich durch Druck schliessen.

Als besonders vorteilhaft haben sich Rastelemente erwiesen, welche wenigstens eine, etwa in der Ebene der Spannkante verlaufende Blattfeder und wenigstens je einen, vorzugsweise auslenkbaren Spannhaken aufweisen, welcher über das Ende der Blattfeder einrastbar ist. Blattfeder und Spannhaken werden dabei beim Verrasten leicht ausgelenkt. Der Spannhaken kann dabei beispielsweise gelenkig gelagert sein, so dass er im eingerasteten Zustand durch die Kraft der Blattfeder in der Einrastposition gehalten wird, während er nach der Entlastung ausschwenkbar ist. Das Einschwenken in die Rastposition könnte dabei durch magnetische Mittel erfolgen.

Die Blattfedern sind vorzugsweise am Gewindering angeordnet. Auf diese Weise ist der relative Abstand zwischen Spannhaken und Blattfeder stets etwa gleich gross, unabhängig von der gewählten Einstellung des Gewinderinges.

Als besonders vorteilhaft hat sich eine gleichmässige Verteilung von vier Rastelementen am Adaperrahmen in einer Winkelteilung von 90° erwiesen. Je nach der Dimension des eingesetzten Folienrahmens könnte aber auch eine andere Anzahl oder eine andere Verteilung der Rastelemente gewählt werden. Dies gilt insbesondere dann, wenn der Folienrahmen nicht kreisringförmig ausgebildet ist.

Um ein stets gleichbleibendes und präzises Zusammentreffen der Rastelemente zu gewährleisten, ist am Adapterrahmen wenigstens ein Positionierelement zum gegenseitigen Positionieren von Klemmring und Basisring angeordnet. Als Anschlagmittel zum Befestigen des Adapterrahmens in einer Behandlungsvorrichtung kann der Basisring eine Referenzfläche und wenigstens ein Führungs- und/oder Positioniermittel wie z.B. eine seitlich angeordnete Positionierklaue aufweisen. Die Referenzfläche ermöglicht dabei eine exakte Ausrichtung der Trägerfolie auf eine vorbestimmte Behandlungsebene und die Positionierklauen erlauben eine winkelgenaue Befestigung des Adapterrahmens. Um die Lebensdauer eines Adapterrahmens zu verlängern bzw. den Verschleiss zu reduzieren oder auch aus herstellungstechnischen Gründen können die Referenzfläche und das Führungs- und/oder Positioniermittel durch einen Einsatz gebildet werden, der aus einem anderen, z.B. verschleissfesterem Material als der übrige Basisring besteht. Denkbar wäre etwa ein Einsatz aus Stahl, aus Hartmetall oder aus einem keramischen Material.

Schliesslich betrifft die Erfindung auch noch eine Vorrichtung für die Behandlung eines flächigen Werkstücks, insbesondere eines Halbleiterwafers, gemäss dem Oberbegriff von Anspruch 16. Derartige Vorrichtungen zum Sägen, Sortieren oder Bestücken arbeiten in der Regel immer als Voll- oder Halbautomaten. Aus einem Magazin wird ein bereitgestellter Folienrahmen mit einem darauf plazierten Werkstück entnommen und durch Transportmittel einem Aufnahmetisch zum Festhalten des Werkstückes im Wirkbereich einer Arbeitsstation zugeführt. Die erfindungsgemässe Vorrichtung ist gekennzeichnet durch die Merkmale im Anspruch 16.

Durch einfaches Austauschen der Adapterrahmen können auf besonders einfache Weise unterschiedliche Grössen von Folienrahmen verarbeitet werden.

Das Transportmittel beinhaltet dabei wenigstens teilweise eine Lade- und Spannvorrichtung, an der ein Folienrahmen in einen Adapterrahmen geladen und seine Trägerfolie im Adapterrahmen nachgespannt wird. Dieses Transportmittel erfüllt somit ersichtlicherweise zwei verschiedene Funktionen, indem es den Adapterrahmen handhabt bzw. die Folie nachspannt und gleichzeitig den Adapterrahmen wenigstens über einen Teil der Wegstrecke dem Arbeitstisch zuführt. Das Nachspannen der Trägerfolie erfolgt somit nicht mehr wie bisher am Aufnahmetisch selbst, sondern in einem anderen Bereich der Maschine. Trotzdem wird der Spannvorgang automatisch durchgeführt.

Die Behandlungsvorrichtung verfügt vorteilhaft über eine Einschubvorrichtung zum Einschieben eines leeren Adapterrahmens in die Lade- und Spannvorrichtung. Eine Bedienungsperson braucht somit lediglich einen Adapterrahmen in die Einschubvorrichtung einzulegen, wobei die exakte Plazierung in der Lade- und Spannvorrichtung automatisch erfolgt. Die Lade- und spannvorrichtung weist vorteilhaft einen Hubtisch auf, der aus einer Ladeposition in eine Spannposition gegen eine Klemmringaufnahme verschiebbar ist, wobei der Hubtisch den Basisring und die Klemmringaufnahme den Klemmring eines Adapterrahmens trägt, und wobei in der Spannposition der Adapterrahmen zusammengespannt wird. Der Hubtisch hat somit die Aufgabe, die Spannkraft für das Schliessen des Adapterrahmens aufzubringen bzw. den entsprechenden Weg zurückzulegen. Nach dem Zusammenspannen des Adapterrahmens wird dieser nur noch von der Klemmringaufnahme festgehalten.

Der Hubtisch ist vorteilhaft so ausgestaltet, dass er auch unmittelbar einen leeren Adapterrahmen aus der Einschubvorrichtung herausheben kann. Zu diesem Zweck kann er in eine Übergabeposition abgesenkt werden, in welcher er unter der Ebene der Einschubvorrichtung liegt. Das Magazin ist höhenverstellbar neben dem Hubtisch angeordnet, wobei für die planparallele Übergabe eines Folienrahmens aus einem Magazinfach auf einen auf dem Hubtisch liegenden Basisring ein Extraktor vorgesehen ist. Das Magazin wird jeweils so verstellt, dass der zu entnehmende Folienrahmen auf der richtigen Ebene liegt. Zum Einschieben der Einschubvorrichtung kann das Magazin ganz angehoben werden.

Aus maschinentechnischen Gründen liegen Hubtisch und Aufnahmetisch in bestimmten Fällen nicht in der gleichen Ebene. Es ist daher vorteilhaft, wenn die Klemmringaufnahme mit dem zusammengespannten Adapterrahmen aus der Ebene des Hubtisches in die Ebene des Aufnahmetisches verschiebbar und/oder schwenkbar ist. Die Klemmringaufnahme kann dabei beispielsweise eine Schwenkbewegung von 90° von einer horizontalen in eine vertikale Ebene ausführen. Ein allenfalls noch verbleibender Weg zwischen der Klemmringaufnahme und dem Aufnahmetisch kann mit einer Endtransportvorrichtung, insbesondere mit einem Litt zum Transportieren eines Adapterrahmens zum Aufnahmetisch zurückgelegt werden. Selbstverständlich wäre es aber auch denkbar, dass die gesamte Klemmringaufnahme als verschiebbare Einheit ausgebildet ist.

Eine besonders rationelle Arbeitsweise kann mit der Vorrichtung erreicht werden, wenn die Transportmittel in einem Bereich zwischen der Lade- und Spannvorrichtung und dem Aufnametisch Aufnahmemittel zur Aufnahme von wenigstens zwei Adapterrahmen aufweisen, so dass ein geladener Adapterrahmen in einer Parkposition bereitstellbar ist. Auf diese Weise kann jeweils ein Folienrahmen in einem ersten Adapterrahmen abgearbeitet werden, während ein anderer Folienrahmen in einen zweiten Adapterrahmen geladen und gespannt wird. Die Maschine arbeitet somit stets mit wenigstens zwei Adapterrahmen und sie muss nach dem Abarbeiten eines Folienrahmens am Aufnahmetisch nicht angehalten werden, bis der Folienrahmen zurück ins Magazin geschoben ist und der neue Folienrahmen im Adapterrahmen verspannt ist. Vielmehr ist ein schneller Wechsel am Aufnahmetisch möglich, weil stets ein geladener Adapterrahmen bereitgestellt ist.

Weitere Einzelmerkmale und Vorteile der Erfindung ergeben sich aus den Zeichnungen und aus dem nachstehend beschriebenen Ausführungsbeispiel. Es zeigen:
- Fig. 1: eine Draufsicht auf einen Folienrahmen mit aufgeklebtem und bereits gesägtem Wafer,
- Fig. 2: einen Querschnitt durch den Folienrahmen gemäss Fig. 1,
- Fig. 3: eine Draufsicht auf einen Klemmring,
- Fig. 4: ein Querschnitt durch den Klemmring gemäss Fig. 3 in der Ebene A - A in vergrössertem Massstab,
- Fig. 5: eine Draufsicht auf einen Gewindering,
- Fig. 6: ein Querschnitt durch den Gewindering gemäss Fig. 5 in der Ebene B - B in vergrössertem Massstab,
- Fig. 7: eine Draufsicht auf einen Basisring,
- Fig. 8: ein Querschnitt durch den Basisring gemäss Fig. 7 in vergrössertem Massstab,
- Fig. 9: eine perspektivische Darstellung eines gespannten Adapterrahmens ohne Folienrahmen,
- Fig. 10: ein Querschnitt durch einen geöffneten Adapterrahmen vor dem Einspannen eines Folienrahmens,
- Fig. 11: der Adapterrahmen gemäss Fig. 10 nach dem Verrasten,
- Fig. 12: eine perspektivische Darstellung eines Bestückungsautomaten,
- Fig. 13: ein Querschnitt durch den Bestückungsautomaten gemäss Fig. 12,
- Fig. 14 bis 16: ein Ladevorgang eines Adapterrahmens in schematischen Darstellungen, und
- Fig. 17 und 18: das Kreuzen von zwei Adapterrahmen in schematischen Darstellungen.

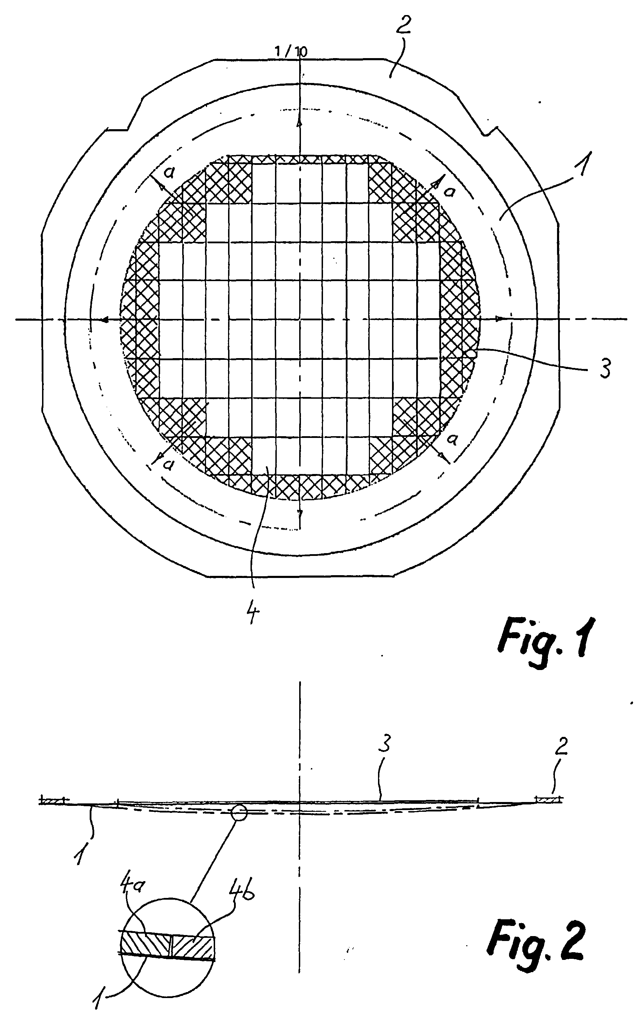

Fig. 1 zeigt einen an sich bekannten Folienrahmen 2, der mit einer Trägerfolie 1 aus elastischem Kunststoffmaterial bespannt ist. Auf der Trägerfolie ist ein Halbleiterwafer 3 aufgeklebt, der bereits gesägt ist, so dass die einzelnen Chips 4 voneinander abgetrennt sind. Für die Abnahme dieser Chips im Bestückungsautomaten muss die Trägerfolie 1 in Pfeilrichtung a expandiert werden, so dass sich die Zwischenräume zwischen den Chips vergrössern. Der Folienrahmen 2 besteht vorzugsweise aus Metall und er ist an seinem Umfangsbereich mit Aussparungen und Abflachungen versehen, um ihn beispielsweise in einem Magazin positionieren zu können.

Aus dem Querschnitt gemäss Fig. 2 ist ersichtlich, dass je nach Durchmesser des Folienrahmens 2 ein durch strichpunktierte Linien angedeuteter Foliendurchhang eintreten kann. Der bereits unterteilte Wafer folgt diesem Durchhang, wobei einzelne Chips 4a bzw. 4b mit ihren Oberkanten aneinanderstossen können. Durch Beschleunigungs- bzw. Verzögerungsmanöver bei der Handhabung des Folienrahmens in einem Automaten kann dieser Durchhang dabei noch kurzzeitig stark vergössert werden. Der Durchhang lässt sich nur mit einem Nachspannen der Trägerfolie innerhalb des Folienrahmens verhindern, was mit einem nachstehend beschriebenen Adapterrahmen möglich ist.

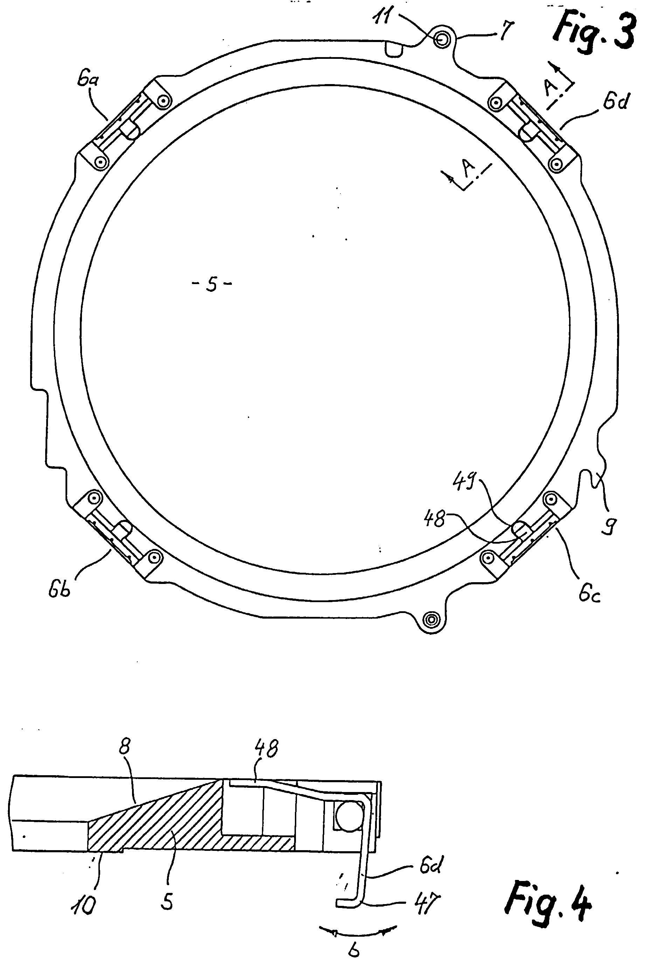

Der eingangs beschriebene Adapterrahmen besteht im wesentlichen aus einem Klemmring und aus einem Basisring, wobei der Basisring als verstellbare Auflageschulter mit einem Gewindering versehen ist. Diese drei Bauteile und deren Funktion werden nachstehend anhand der Figuren 3 bis 8 näher beschrieben.

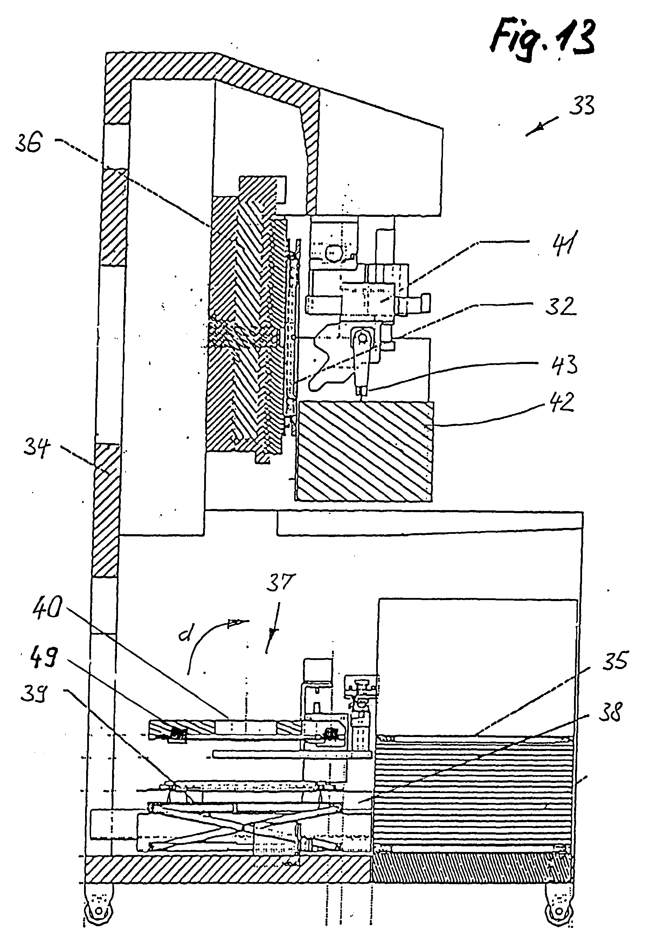

Der Klemmring 5 gemäss den Fig. 3 und 4 ist im wesentlichen kreisringförmig ausgebildet, wobei am Aussenumfang ebenfalls Anschlagmittel 9 zum Positionieren des Klemmrings in einer Klemmringaufnahme vorgesehen sind. Am Aussenumfang verteilt, mit einer Winkelteilung von 90°, sind vier Spannhaken 6a, 6b, 6c, 6d. Diese sind als Winkelhebel ausgebildet und derart schwenkbar befestigt, dass das Hakenende 47 in Pfeilrichtung b federnd aufschwenken kann. Ein abgewinkelter Hebelarm 48 wird z.B. durch ein Elektromagnet 49 in der Klemmringaufnahme 40 betätigt (Fig. 13), womit die Spannhaken geöffnet werden können. In der Schliessstellung werden sie durch Federkraft gehalten. Es wäre aber auch denkbar, die Spannhaken fest einzuspannen, jedoch federnd auszubilden, so dass sie durch Zug und Druck selber ein- und ausrasten. Zur winkelmässigen Positionierung mit dem Basisring ist eine Positioniernase 7 mit einer Öffnung 11 am Aussenumfang angeordnet.

Auf seiner oben liegenden Innenseite ist der Klemmring 5 mit einer Anschrägung 8 versehen, welche die Wandstärke gegen das Zentrum hin verjüngt. Diese Anschrägung ermöglicht ein Anfahren der Folienoberfläche mit einem Pick-up-Schwenkarm auch an die äussersten Randbereiche der Trägerfolie. Die Unterseite des Klemmrings ist als ebene Spannfläche 10 ausgebildet, welche dazu bestimmt ist, den Folienrahmen 2 niederzupressen.

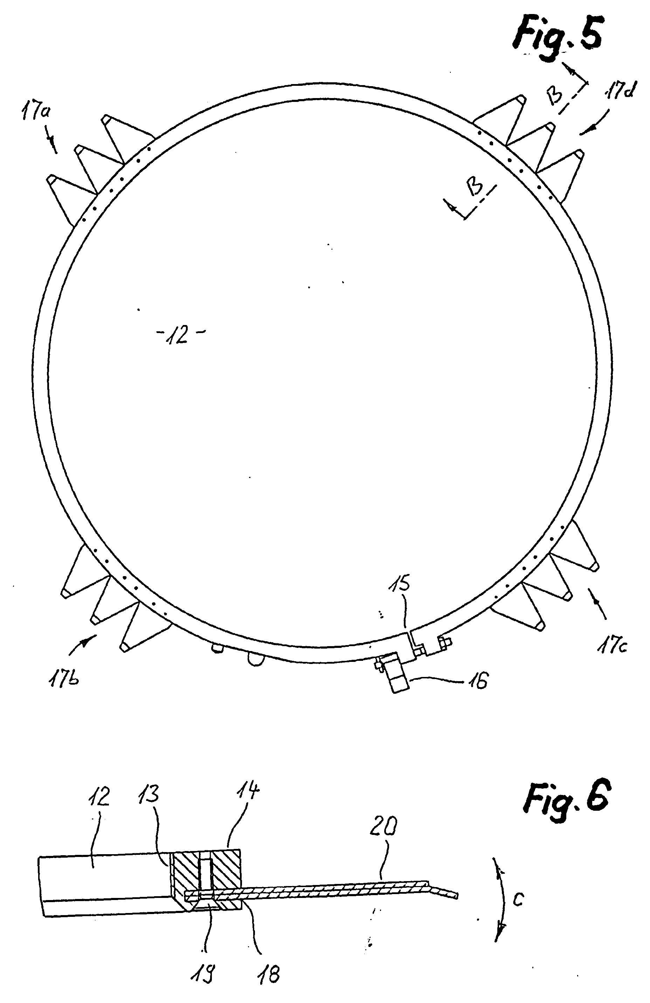

Der beschriebene Klemmring 5 wird zusammen mit einem Gewindering 12 gemäss den Figuren 5 und 6 verrastet. Letzterer verfügt über ein Innengewinde 13, zum Aufschrauben auf einen Basisring. Der Gewindering ist jedoch nicht geschlossen ausgebildet, sondern kann mit einem Schlitz 15 versehen sein, so dass er in der gewünschten Aufschraubposition mit einem Sicherungsverschluss 16 auf dem Basisring arretiert werden kann. die Oberfläche des Gewinderinges ist als plane Auflagefläche 14 für den Folienrahmen ausgebildet.

In der gleichen Winkelteilung wie die Spannhaken am Klemmring sind am Gewindering Federpakete 17a, 17b, 17c, 17d befestigt. Diese bestehen in der Regel aus mehreren einzelnen Blattfedern 20 mit einer vorzugsweise dreieckigen Grundform. Die Blattfedern sind in einem Schlitz 18 mittels Senkschrauben 19 am Gewindering fixiert. Um sicherzustellen, dass der Gewindering mit dem Sicherungsverschluss 16 immer in einer korrekten winkelposition arretiert wird, kann eine Markierung vorgesehen sein, die mit einer Markierung am Basisring zusammenwirkt. Beim Einrasten bzw. Ausrasten bewegen sich die Enden der Blattfedern 20 in Pfeilrichtung c. Das äusserste Ende der Blattfedern ist leicht nach unten geneigt, um ein sicheres Einhängen im gespannten Zustand zu gewährleisten.

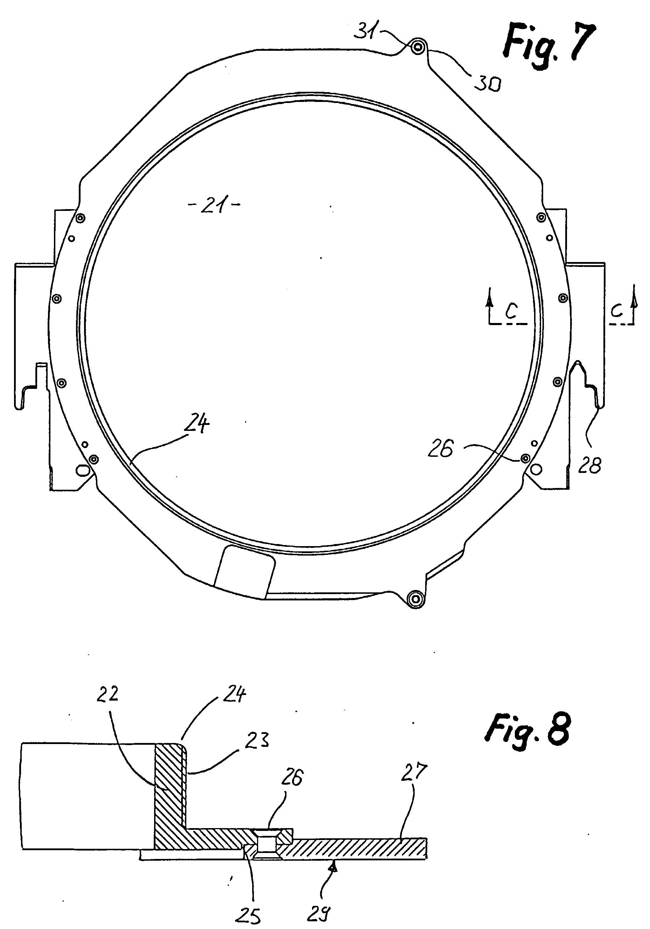

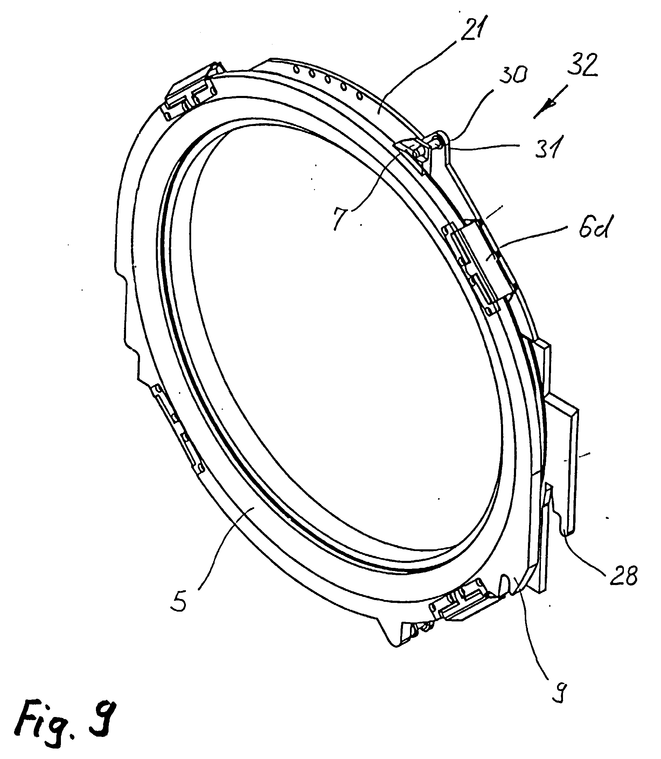

Der Basisring 21 gemäss den Figuren 7 und 8 ist im wesentlichen ebenfalls kreisringförmig ausgebildet. Er verfügt über einen Halsabschnitt 22, der mit einem Aussengewinde 23 zum Aufschrauben des Gewinderings 12 versehen ist. Das obere Ende des Halsabschnitts bildet dabei die Spannkante 24, über welche die Trägerfolie gespannt wird. Die Spannkante ist immer auch die Arbeitsebene an der Folie, unabhängig davon, in welcher Position der Gewindering arretiert wurde. Am Basisring 21 kann eine Typenkodierung vorgesehen sein, so dass die Maschine die Art der verwendeten Basisringe erkennt.

Die Schnittstelle bzw. die Anschlagmittel zur Befestigung des Adapterrahmens auf einem Aufnahmetisch sind am Basisring 21 angeordnet. Da es sich dabei um Teile handelt, die einer besonders hohen Belastung unterworfen sind, bestehen sie vorteilhaft aus einem härteren Material als der übrige Basisring. Zu diesem Zweck ist auf der Unterseite des Basisrings eine Nut 25 vorgesehen, welche einen Einsatz 27 aufnimmt. Die Befestigung des Einsatzes erfolgt beispielsweise über Senknieten 26. Der Einsatz 27 ist mit einer exakt masshaltigen Referenzfläche 29 versehen und weist seitliche Positioniernasen 28 auf, an denen der ganze Adapterrahmen positioniert und befestigt werden kann.

Für die relative Positionierung gegenüber dem Klemmring ist eine Positioniernase 30 vorgesehen, die einen Stift 31 trägt. Dieser dringt in die Öffnung 11 an der Positioniernase 7 des Klemmrings ein. Damit ist gleichzeitig auch sichergestellt, dass sich bei der Bearbeitung der Klemmring nicht relativ zum Basisring verdrehen oder verschieben kann.

Fig. 9 zeigt einen zusammengespannten Adapterrahmen 32, wobei der Gewindering allerdings nicht sichtbar ist. Deutlich erkennbar ist jedoch die relative Positionierung zwischen Klemmring 5 und Basisring 21 an den Positioniernasen 7 bzw. 30.

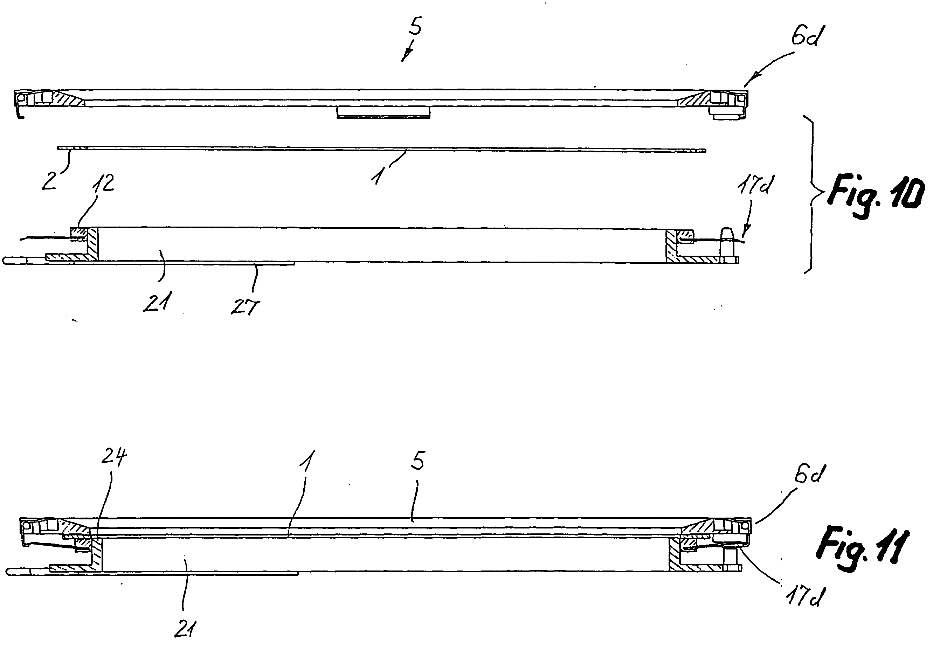

Die Figuren 10 und 11 zeigen den Adapterrahmen vor und nach dem Verrasten. Ein Folienrahmen 2 wird dabei zentrisch derart auf dem Basisring 21 aufgelegt, dass die Spannkante 24 die Trägerfolie 1 ausserhalb des Werkstücks abstützt. Durch relatives Zusammenschieben von Klemmring und Basisring wird der Folienrahmen 2 aus der Ebene der Spannkante 24 auf den Gewindering 12 niedergepresst. Nach dem Einrasten der Spannhaken in den Federpaketen wird die Spannkraft durch die Blattfedern aufrechterhalten. Die Dicke des Folienrahmens 2 muss dabei nicht berücksichtigt werden, weil die Foliendehnung durch die Relativlage des Gewinderings definiert ist.

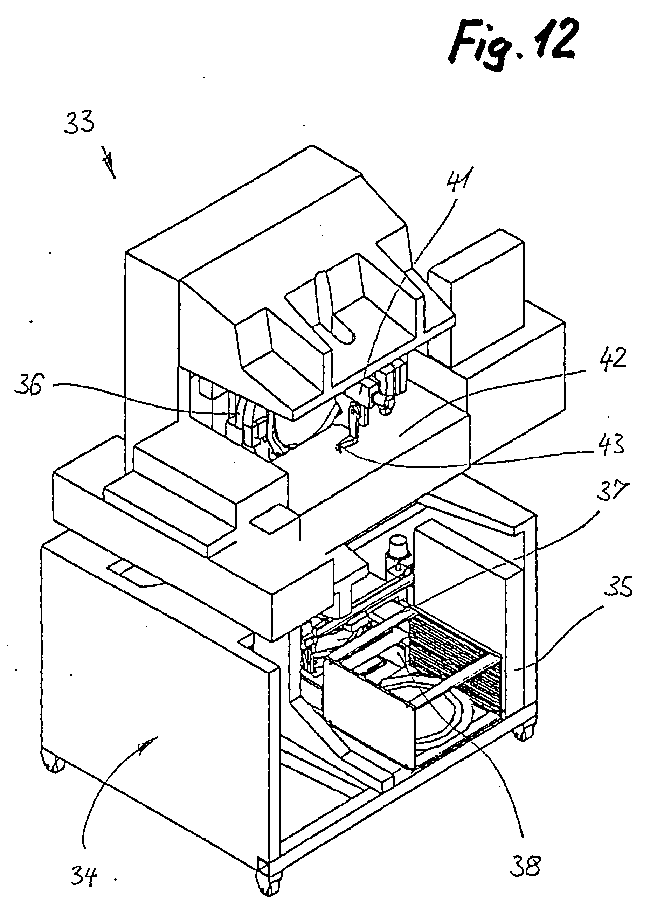

Fig. 12 zeigt gesamthaft einen Bestückungsautomaten 33 (Die Bonder), mit dessen Hilfe Chips von einem Wafer abgenommen und an einem Substrat, beispielsweise auf einer Leiterplatte befestigt werden können. Der Bestückungsautomat verfügt über ein Maschinengestell 34, in dessen unterem Bereich eine Lade- und Spannvorrichtung 37 zum Laden und Spannen der beschriebenen Adapterrahmen 32 angeordnet ist.

Mit einer Einschubvorrichtung 38 können der Maschine leere Adapterrahmen zugeführt werden. In einem Magazin 35 sind mehrere Folienrahmen bereitgestellt.

Im oberen Teil des Maschinengestelis 34 ist in einer vertikalen Ebene ein drehbarer Aufnahmetisch 36 angeordnet, auf dem die geladenen Adapterrahmen befestigt werden. Eine Transfereinheit 41 ist mit einem Pick-up 43 versehen, der einzelne Chips aus der Ebene des Aufnahmetisches 36 in die Ebene eines Abgabetisches 42 transferieren kann.

Aus Fig. 13 sind weitere Einzelheiten der Lade- und Spannvorrichtung 37 ersichtlich. Diese verfügt über einen Hubtisch 39 und über eine Klemmringaufnahme 40 über dem Hubtisch. Der Hubtisch verfügt über ein Scherengestell und kann einerseits gegen die relativ feststehende Klemmringaufnahme 40 gepresst werden. Der Hubtisch trägt dabei einen Basisring, während der Klemmring an der Klemmringaufnahme 40 befestigt und planparallel gehalten ist. Nach dem Erreichen der entsprechenden Position findet das Verrasten von Klemmring und Basisring statt und der Hubtisch wird wieder abgesenkt. Der geladene und gespannte Adapterrahmen wird dann ausschliesslich an der Klemmringaufnahme 10 gehalten.

Die Auflagefläche des Hubtisches 39 ist mit einer Sensorik ausgerüstet, welche feststellt, ob die Federn eingerastet sind.

Der Hubtisch 39 kann aus seiner Ladeebene aber auch noch vollständig abgesenkt werden. Diese Position wird dann eingenommen, wenn mit der Einschubvorrichtung 38 ein leerer Adapterrahmen in die Maschine eingeführt wird. Der Adapterrahmen kann dann durch Anheben des Hubtisches unmittelbar aus der Einschubvorrichtung herausgehoben werden und zum Öffnen gegen die Klemmringaufnahme 40 gefahren werden.

Das Magazin 35 mit mehreren übereinanderliegenden Magazinfächern zur Aufnahme von Folienrahmen ist höhenverstellbar vor der Lade- und Spannvorrichtung 37 angeordnet. Es wird jeweils derart verstellt, dass ein gefülltes Magazinfach etwa auf der Ebene des Hubtisches 39 liegt. Ein Folienrahmen wird dann mit Hilfe eines speziellen Extraktors 44 aus dem Magazinfach herausgezogen und in die richtige Position auf den Hubtisch gelegt. Zur Positionierung des Folienrahmens auf den Hubtisch kann eine spezielle Positioniervorrichtung vorgesehen sein.

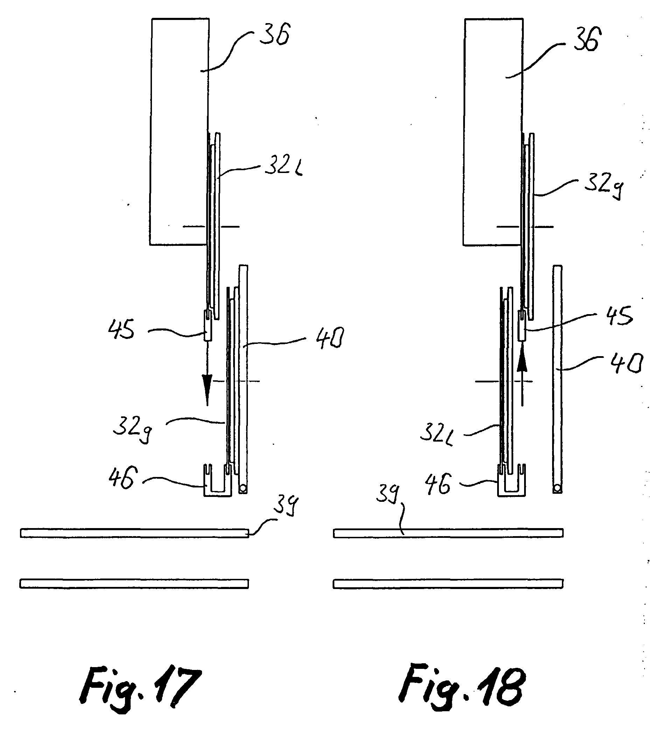

Die Klemmringaufnahme 40 kann in Pfeilrichtung d um 90° in eine vertikale Ebene hochgeschwenkt werden. Diese hochgeschwenkte Position ist in den Figuren 17 und 18 zu erkennen. Aus der vertikalen Lage kann ein Adapterrahmen 32 mit einem Lift 45 zum Aufnahmetisch 36 transportiert und dort in der richtigen Position befestigt werden.

Damit zwischen der Lade- und Spannvorrichtung 37 und dem Aufnahmetisch 36 ein Kreuzen von zwei Adapterrahmen 32 möglich ist, können diese in eine Parkposition gefahren werden. Zu diesem Zweck ist eine Wechselhalterung 46 vorgesehen, welche von einer Übergabeposition von der hochgeschwenkten Klemmringaufnahme 40 in eine dazu planparallel versetzte Parkposition fahrbar ist. Dies ermöglicht ersichtlicherweise, dass zwei Adapterrahmen planparallel kreuzen können, wobei jeweils einer der Adapterrahmen in der Parkposition verbleibt, während der andere Adapterrahmen vom Aufnahmetisch entfernt bzw. dem Aufnahmetisch zugeführt wird. Das Bereitstellen geladener Adapterrahmen könnte aber auch auf andere Weise gelöst werden, z.B. durch ein Karussell, auf dem in einer Ebene mehrere Adapterrahmen aufgenommen werden können und das nach dem Prinzip eines CD-Wechslers arbeitet.

Die Zufuhr eines Folienrahmens vom Magazin 35 zum Aufnahmetisch 36 wird nachstehend anhand von schematischen Figuren nochmals erläutert. Es wird dabei vorausgesetzt, dass die Maschine bereits mit den erforderlichen Adapterrahmen bestückt ist.

Gemäss Fig. 14 wird mit dem Extraktor 44 ein Folienrahmen 2 aus dem Magazin 35 herausgezogen und einem Basisring 21 übergeben, der auf dem Hubtisch 39 aufliegt. An der Klemmringaufnahme 40 ist ein Klemmring 5 befestigt.

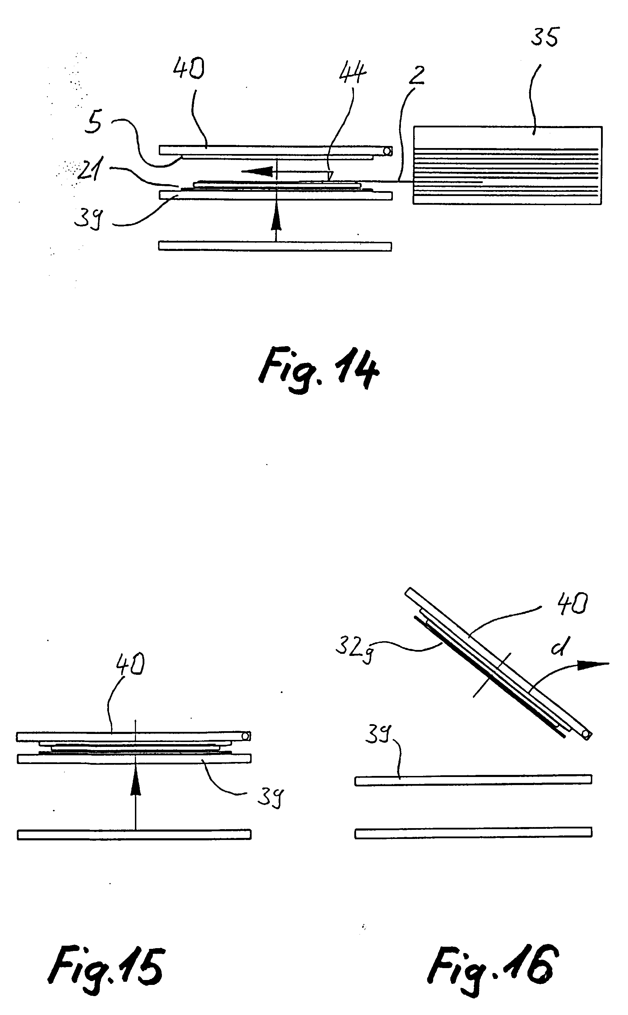

Anschliessend wird der Hubtisch 39 gegen die Klemmringaufnahme 40 gefahren, wie aus Fig. 15 hervorgeht. Beim Erreichen der entsprechenden Einrastposition findet das Verrasten zwischen Klemmring und Basisring statt, wobei die Folie am Folienrahmen 2 nachgespannt wird.

Gemäss Fig. 16 wird die Klemmringaufnahme 40 mit dem geladenen Adapterrahmen 32g in Pfeilrichtung d hochgeschwenkt.

Gemäss Fig. 17 wird der Adapterrahmen 32g in der hochgeschwenkten Position von einer Wechselhalterung 46 erfasst, welche an die Klemmringaufnahme 40 herangefahren ist. Die Wechselhalterung 46 verfügt über eine zweite Aufnahmestelle für einen leeren Adapterrahmen 321, dessen Werkstücke am Aufnahmetisch 36 bearbeitet bzw. entfernt wurden. Dieser Adapterrahmen 321 wird nun mit dem Lift 45 vom Aufnahmetisch 36 zur Wechselhalterung 46 transportiert.

Sobald beide Adapterrahmen in der Wechselhalterung 46 aufgenommen sind, wird letztere planparallel von der Klemmringaufnahme 40 in eine Parkposition weggefahren, wie aus Fig. 18 ersichtlich ist. In dieser Parkposition kann der geladene Adapterrahmen 32g mit dem Lift angehoben und zum Aufnahmetisch 36 transportiert werden, während der Adapterrahmen 321 in der Parkposition wartet. Anschliessend wird die Wechselhalterung 46 wieder so weit gegen die Klemmringaufnahme 40 gefahren, bis diese den Adapterrahmen 321 aufnehmen kann. Die Klemmringaufnahme 40 schwenkt dann mit dem leeren Adapterrahmen 321 zurück in die Ebene des Hubtisches 39, der Adapterrahmen 321 wird geöffnet und der verbrauchte Folienrahmen entfernt. Die Lade- und Spannvorrichtung ist dann bereit für die Übernahme eines neuen Folienrahmens aus dem Magazin.

## Patentansprüche

1. Verfahren zum Behandeln eines flächigen Werkstückes, insbesondere eines Halbleiterwafers (3), das zuerst auf eine über einen Folienrahmen (2) gespannte Trägerfolie (1) aufgeklebt wird, und das bis zu seiner ganzen oder teilweisen Ablösung von der Trägerfolie (1) wenigstens eine Prozess-Stufe durchläuft, dadurch gekennzeichnet, dass der Folienrahmen (2) auf einem wenigstens ein Anschlagmittel aufweisenden Adapterrahmen (32) befestigt wird, an dem die Trägerfolie (1) nachgespannt wird, und dass die Prozess-Stufe auf dem Adapterrahmen (32) durchlaufen wird und mit nachgespannter Trägerfolie abgeschlossen wird, wobei das Anschlagmittel als Schnittstelle zum Positionieren des Adaperrahmens in der Prozess-Stufe dient.

2. Verfahren nach Anspruch 1, dadurch gekennzeichnet, dass das Werkstück (3) auf dem Adapterrahmen (32) in einer Sägevorrichtung in Einzelteile gesägt wird, wobei das Nachspannen der Trägerfolie vor oder nach dem Sägen erfolgt.

3. Verfahren nach Anspruch 1 oder 2, dadurch gekennzeichnet, dass das in mehrere Einzelteile (4) unterteilte Werkstück (3) auf dem Adapterrahmen (32) in einer Bestückungsvorrichtung (33) auf einem Aufnahmetisch (36) in einer Aufnahmeebene gehalten wird, in welcher taktweise Einzelteile (4) von der Trägerfolie (1) abgelöst und in einer Abgabeebene wieder abgesetzt werden.

4. Verfahren nach einem der Ansprüche 1 bis 3, dadurch gekennzeichnet, dass die Trägerfolie 1 am Adapterrahmen (32) mittels eines am Folienrahmen (2) angreifenden Klemmrings (5) über eine zwischen Werkstück (3) und Folienrahmen (2) umlaufende Spannkante (24) an einem Basisring (21) gespannt wird, bis eine vorbestimmte Spannkraft oder eine vorbestimmte Position erreicht ist, und dass anschliessend der Klemmring mit dem Basisring verrastet wird.

5. Verfahren nach Anspruch 4, dadurch gekennzeichnet, dass der Basisring (21) auf einer Hubvorrichtung (39) plaziert wird und nach der Auflage eines Folienrahmens (2) auf die Spannkante (24) zum Verrasten gegen den relativ feststehenden Klemmring (5) gepresst wird.

6. Vorrichtung zum Nachspannen einer über einen Folienrahmen (2) gespannten Trägerfolie (1) für ein flächiges Werkstück (3), insbesondere für einen Halbleiterwafer, gekennzeichnet durch
- einen Basisring (21) mit einer zwischen Werkstück und Folienrahmen umlaufenden Spannkante (24),
- einen am Folienrahmen (2) angreifenden Klemmring (5), und
- Spannmittel zum Gegeneinanderpressen von Basisring und Klemmring,
- wobei die zwischen Basisring und Klemmring liegende Trägerfolie (1) über die Spannkante (24) spannbar ist, und wobei die Vorrichtung einen Adapterrahmen (32) mit Anschlagmitteln (28, 29) zum Einspannen in eine beliebige Behandlungsvorrichtung bildet.

7. Vorrichtung nach Anspruch 6, dadurch gekennzeichnet, dass der Basisring (21) eine relativ zur Ebene der Spannkante (24) verstellbare Auflageschulter für den Folienrahmen (2) aufweist.

8. Vorrichtung nach Anspruch 7, dadurch gekennzeichnet, dass die Auflageschulter durch einen Gewindering (12) gebildet wird, der auf einem mit einem Aussengewinde (23) versehenen Halsabschnitt (22) am Basisring (21) aufgeschraubt ist.

9. Vorrichtung nach einem der Ansprüche 6 bis 8, dadurch gekennzeichnet, dass als Spannmittel mehrere über den Umfang des Adapterrahmens (32) verteilte Rastelemente angeordnet sind, an denen der Klemmring (5) und der Basisring (21) unter Federvorspannung miteinander verrastbar sind.

10. Vorrichtung nach Anspruch 9, dadurch gekennzeichnet, dass die Rastelemente wenigstens je eine, etwa in der Ebene der Spannkante verlaufende Blattfeder (20) und wenigstens je einen, vorzugsweise auslenkbaren Spannhaken (6) aufweisen, welcher über das Ende der Blattfeder einrastbar ist.

11. Vorrichtung nach Anspruch 8 und Anspruch 10, dadurch gekennzeichnet, dass die Blattfedern am Gewindering (12) und die Spannhaken am Klemmring (5) angeordnet sind.

12. Vorrichtung nach Anspruch 10 oder 11, dadurch gekennzeichnet, dass am Adapterrahmen (32) vier Rastelemente in einer Winkelteilung von vorzugsweise 90° angeordnet sind.

13. Vorrichtung nach einem der Ansprüche 6 bis 12, dadurch gekennzeichnet, dass am Adapterrahmen (32) wenigstens ein Positionierelement (7, 30) zum gegenseitigen Positionieren von Klemmring (5) und Basisring (21) angeordnet ist.

14. Vorrichtung nach einem der ansprüche 6 bis 13, dadurch gekennzeichnet, dass der Basisring (21) als Anschlagmittel eine Referenzfläche (29) und wenigstens ein Führungs- und/oder Positioniermittel (28) aufweist.

15. Vorrichtung nach Anspruch 14, dadurch gekennzeichnet, dass die Referenzfläche (29) und das Führungs- und/oder Positioniermittel (28) durch einen Einsatz (27) gebildet wird, der aus einem anderen Material als der übrige Basisring besteht.

16. Vorrichtung für die Behandlung eines flächigen Werkstücks (3), insbesondere eines Halbleiterwafers, insbesondere zur Durchführung des Verfahrens nach einem der Ansprüche 1 bis 5, und insbesondere unter Verwendung eines Adapterrahmens (32) nach einem der Ansprüche 6 bis 15, mit einem Magazin (35) zum Bereitstellen mehrerer Folienrahmen (2) mit je einem auf einer Trägerfolie geklebten Werkstück (3), einem Aufnahmetisch (36) zum Festhalten des Werkstücks im Wirkbereich einer Arbeitsstation, und mit Transportmitteln zum Transportieren der Folienrahmen vom Magazin zum Aufnahmetisch, dadurch gekennzeichnet, dass die Transportmittel wenigstens teilweise eine Lade- und Spannvorrichtung (37) beinhalten, an der ein Folienrahmen (2) in einen Adapterrahmen (32) geladen und seine Trägerfolie (1) im Adapterrahmen nachgespannt wird.

17. Vorrichtung nach Anspruch 16, dadurch gekennzeichnet, dass die Transportmittel in einem Bereich zwischen Lade- und Spannvorrichtung (37) und dem Aufnahmetisch (36) Aufnahmemittel (46) zur Aufnahme von wenigstens zwei Adapterrahmen (32) aufweisen, so dass ein geladener Adapterrahmen in einer Parkposition bereitstellbar ist.
